# EUROPEAN PATENT SPECIFICATION

(11) **EP 4 674 229 B1**
(45) Date of publication and mention of the grant of the patent: **28.10.2026**
(21) Application number: 24707049.3
(22) Date of filing: 26.02.2024
(51) Int. Cl.: H05B 45/20, H10H 20/855, H10W 90/00

(54) **LED LIGHTING ARRANGEMENT**
LED-BELEUCHTUNGSANORDNUNG
AGENCEMENT D'ÉCLAIRAGE À DEL

(30) Priority: 02.03.2023 EP 23159572
(43) Date of publication of application: 07.01.2026
(73) Proprietor: Signify Holding B.V., 5656 AE Eindhoven (NL)
(72) Inventor: CERTAIN, Stephan, 5656 AE Eindhoven (NL); BOULIN, Yves Sebastien, 5656 AE Eindhoven (NL)
(74) Representative: Verweij, Petronella Daniëlle
(86) International application number: PCT/EP2024/054763
(87) International publication number: WO 2024/179961

(56) References cited:
- US-A1- 2015 167 922
- US-A1- 2017 045 201

## Description

### FIELD OF THE INVENTION

The present invention relates to the field of lighting, and in particular to LED lighting arrangements.

### BACKGROUND OF THE INVENTION

The use of artificial lighting is becoming increasingly common, with LED lighting arrangements becoming more popular due to their high energy efficiency and flexibility of use.

LED lighting arrangements are known from US 2015/167922 A1.

A growing concern in the field of LED lighting is color inconsistency within a distribution of light output by an LED lighting arrangement. This effect is commonly called Color-over-Angle (CoA). The effect of Color-over-Angle can cause the appearance of yellow rings or stripes at large angles in the far-field of a (white) LED. This CoA effect is particularly visible in LED lighting arrangements that make use of phosphor-converted light emitting diodes (PC-LEDs).

There is therefore a desire to provide a lighting arrangement that is able to avoid or mitigate the effects of Color-over-Angle.

### SUMMARY OF THE INVENTION

The invention is defined by an LED lighting arrangement in accordance with claim 1. Further preferred embodiments are defined in the dependent claims.

According to examples in accordance with an aspect of the invention, there is provided an LED lighting arrangement comprising an array of LED packages. The array of LED packages comprises a first set of one or more first type of LED packages, each LED package in the first set having an LED and a respective combination of a dome-shaped lens and a collimating reflector; and a second set of one or more second type of LED packages, each LED package in the second set having an LED not having/being free from a respective dome-shaped lens and from a respective collimating reflector, wherein each LED in the first and second set of one or more LED packages is a phosphor-converted light emitting diode.

The present invention recognizes that different types of LED packages result in different CoA behavior. More particularly, LED packages having a respective combination of a collimating reflector and a dome-shaped lens act to collimate blue light in the center of a beam to a greater extent and to surround the bluish center by a (concentric) more yellowish ring of light, which on its turn is surrounded by a more whitish (concentric) ring of light, while LED packages for which no respective dome-shaped lens and no respective collimating relfector is provided have in radial direction a gradual gradient from bluish light to increasing yellowish light. The present disclosure recognizes that by mixing these two types of LED packages, i.e. a first type of LED package comprising an LED a respective combination of a collimating reflector and a dome-shaped lens, and a second type of LED package comprising an LED without (or being free from) said combination it is possible to compensate and/or improve the spread of yellow and blue light throughout the overall distribution of light output by the LED lighting arrangement.

The proposed approach therefore provides an LED lighting arrangement with a more even color distribution, without requiring expensive and inefficient color filtering elements.

The respective lens-reflector combination of each LED package is configured and sized to perform beamshaping only on light emitted by the LED of that LED package. This is distinct from a larger common lens that receives light from multiple LEDs to perform beamshaping thereon.

The first set of one or more LED packages may comprise no fewer than 30% of the total number of LED packages in the array of LED packages. For instance, the first set of one or more LED packages may comprise no fewer than 45% of the total number of LED packages in the array of LED packages.

The second set of one or more LED packages may comprise no fewer than 30% of the total number of LED packages in the array of LED packages. For instance, the second set of one or more LED packages may comprise no fewer than 45% of the total number of LED packages in the array of LED packages.

Preferably, the first set of one or more LED packages and the second set of one or more LED packages each comprise no fewer than 45% of the total number of LED packages in the array of LED packages. It has been recognized that an even distribution between the number of LED packages in the first and second sets improves the color uniformity of light output by the overall LED lighting arrangement across a wider range of angles. Thus, the CoA effect is mitigated to a greater effect when the number of LED packages in the first and second sets are equal or near-equal.

The first set of one or more LED packages may comprise no fewer than 1 LED package, such as at least 10 LED packages. In some examples, the second set of one or more LED packages comprises no fewer than 1 LED package, such as at least 10 LED packages.

However, embodiments may make use of any number of different LED packages, e.g., only a single LED package in the first set of one or more LED packages and/or (only) a single LED package in the second set of one or more LED packages.

The combination of the respective collimating reflector and the respective dome-shaped lens may be formed as a single, integrated, optical element, for example as a lens having a TIR, parabolic outer surface extending between a light input surface and a light output surface of the integrated optical element.

Preferably, each LED in the first and second set of one or more LED packages is a phosphor-converted white light emitting diode, i.e., a white light LED. Embodiments are particularly advantageous when used with white light PC-LEDs, as the CoA effect is particularly prevalent when an LED is configured or designed to produce a wide range or spectrum of color (e.g., to emulate white light).

The second set of one or more LED packages may be interspersed or interleaved amongst the first set of one or more LED packages. This provides a more even distribution of light output by the array of LED packages, reducing any striping or other patterning effects.

The LED lighting arrangement may comprise a common reflector for collimating light output by the array of LED packages to provide a relatively narrow beam having a FWHM (Full Width at Half Maximum intensity) of, for example <= 60°, such as <= 45° or <=30°. The effect of CoA is particularly prevalent when an LED lighting arrangement comprises a common collimating reflector. Use of the proposed concept in such an embodiment is therefore particularly advantageous to reduce the impact of the common collimating reflector on the uniformity of light distribution due to the CoA effect.

The LED lighting arrangement may comprise a common lens, distanced from the array of LED packages, for performing beamshaping on light output by the array of LED packages. This common lens is distinct from the respective dome-shaped lens associated with a single LED package of the first set of one or more LED packages. In particular, the common lens may be configured or designed to receive light from a plurality of different LEDs, whereas a respective dome-shaped lens of any given LED package may be associated with only a single LED.

The common lens may, for instance, be no less than 5mm from the array of LED packages, e.g., no less than 7mm from the array of LED packages.

In some examples, no fewer than 90% of the LEDs in the array of LED packages comprise the same phosphor for performing conversion of light. Put another way, in no fewer than 90% of the PC-LEDs, the material of the phosphor may be the same. Preferably, the thickness and/or shape of the phosphor in no fewer than 90% of the PC-LEDs is the same and/or effectively the same. More preferably, all or essentially all phosphor-converted light emitting diodes of both the first and second set of LED packages comprise the same phosphor for conversion of light (in the context of the invention "essentially all" means at least 95% such as at least 99%). In particular examples, each LED in the array of LED packages comprise the same phosphor.

In some examples, the first and second sets of one or more LED packages are arranged in a grid in which the first and second sets of one or more LED packages alternate with one another along both a column direction and a row direction, for example in a square grid. In this way, each LED package in a first set has only (one or more) LED packages from the second set as closest neighbors and vice versa.

These and other aspects of the invention will be apparent from and elucidated with reference to the embodiment(s) described hereinafter.

### BRIEF DESCRIPTION OF THE DRAWINGS

For a better understanding of the invention, and to show more clearly how it may be carried into effect, reference will now be made, by way of example only, to the accompanying schematic drawings, in which:
Fig. 1A-B illustrates a first type and a second type of LED package;
Fig. 1C illustrates a luminaire or LED lighting arrangement;
Fig. 2 illustrates the intensity distribution or spread of yellow light emitted by different types of a PC-LED;
Fig. 3 illustrates the intensity distribution or spread of blue light emitted by different types of a PC-LED;
Fig. 4 illustrates a portion of an array of LED packages;
Fig. 5 illustrates the effect of a proposed embodiment on color uniformity;
Fig. 6 illustrates one pattern for the array of LED packages;
Fig. 7 illustrates another pattern for the array of LED packages;
Fig. 8 illustrates yet another pattern for the array of LED packages;
Fig. 9 illustrates another pattern for the array of LED packages; and
Fig. 10 illustrates some simplified patterns for the array of LED packages.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

The invention provides an LED lighting arrangement comprising an array of LED packages of different types. A first type comprises a respective domed lens and a respective collimating reflector and a second type does neither comprise a respective domed lens nor a respective collimating reflector. The LED in each type of LED package is a phosphor-coated light emitting diode.

A domed lens is well known in the prior art, and refers to a lens having the shape of a (spherical) dome or spherical cap. Of course, a domed lens does not need to be precisely even, symmetrical or regular in shape, but rather refers to a lens having a continuous, curved (outer) surface that meets at an apex or point.

Embodiments are based on the realization that different types of LED package have different distributions of light spectra. In particular, an LED package having a respective domed lens will produce light that has blue light concentrated closer to the optical axis of an LED package compared to an LED package without a domed lens. This recognition is exploited to produce an array of LED packages of different types that provides more uniform distribution of light/color across different angles of light output by the array of LED packages.

Proposed approaches can be employed in any form of LED lighting arrangement, but find particular use in LED lighting arrangements comprising a common lens and a common collimating reflector.

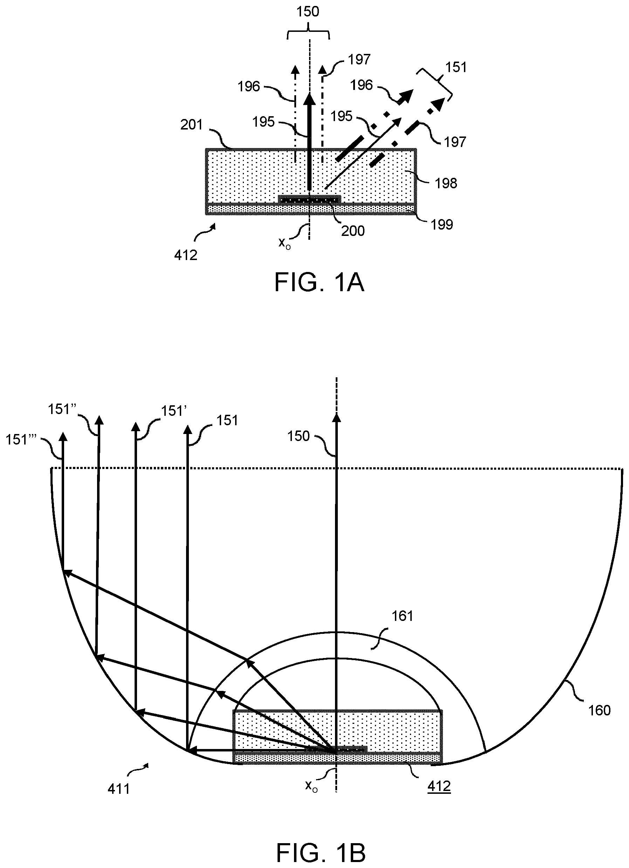

Figures 1A-B illustrates a first type and a second type of LED package. In Figure 1A a second type of a phosphor-converted LED, PC-LED, package 412 is shown comprising a LED 200 on a carrier 199 and a phosphor conversion layer 198 having an outer surface 201 and covering the LED 200 and (part of) the carrier. In operation, the LED emits (relatively saturated) blue light 195 that is partly converted by the phosphor conversion layer 198 in longer wavelengths, for example green light 196 and red light 197. With increasing the path length of the blue light from the LED 200 through the phosphor conversion layer 198 to the outer surface 201 the degree of conversion of blue light 195 into green 196 and red light 197 increases (the degree of conversion is indicated by the thickness of the arrows). This means that blue light emitted in a direction along/parallel to xₒ is converted to a lesser degree than blue light emitted in a direction at an (large) angle with xₒ. The combination of blue light and partly converted blue light in the direction along xₒ therefore results in more bluish light 150, while the combination of blue light and partly converted blue light in the direction at large angles with Xo results in more yellowish light 151. The beam of light thus emitted by the second type of PC-LED package has a more bluish region around the optical axis xₒ surrounded by a yellow ring with increased angle with / distance from the optical axis xₒ.

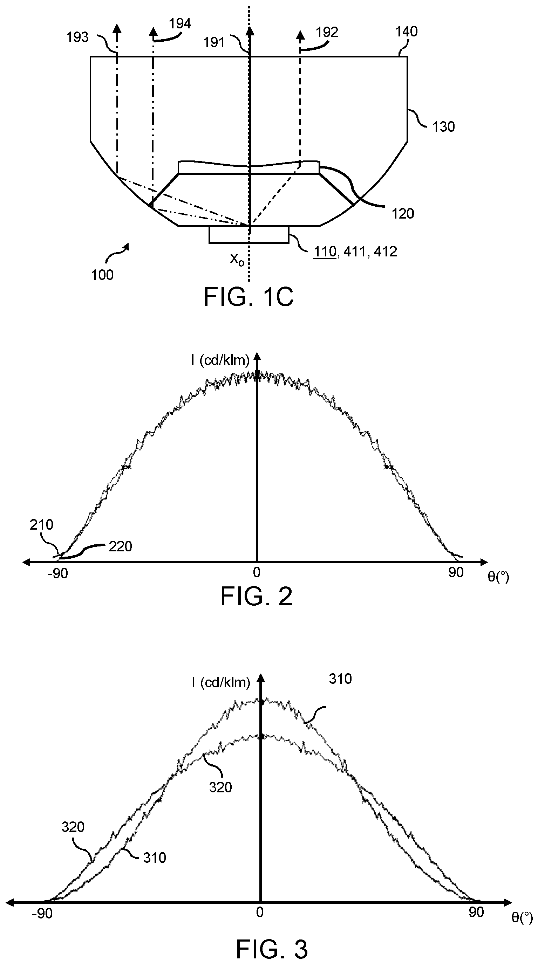

Figure 1B shows a first type of PC-LED package 411 comprising a second type of PC-LED package 412, a respective dome-shaped lens 161 and a respective collimating reflector 160 accommodating the second type of PC-LED package 412 and the respective dome-shaped lens 161. The effect of the respective dome-shaped lens 161 and respective collimating reflector 160 is that the lower the angle (with respect to the optical axis xₒ) of light ray 151,151',151",151‴ emitted by the LED 200 and received by the respective collimating reflector 160 - the closer this light is to the optical axis xₒ when it is reflected and redirected by the respective collimating reflector 160. This is best illustrated with, for example, the light rays 151 and 151"'. The light ray 151, which was emitted at a larger angle with respect to the optical axis xₒ than the light ray 151‴, becomes closer to the optical axis xₒ upon reflection at the respective collimating reflector 160 than the light ray 151‴ in the respective light beam as emitted, in operation, by the first type of LED package 411. This means that the color gradient in radial direction from the optical axis xₒ of the light beam as emitted by the first type of PC-LED package 411 is more or less inverse to the color gradient in radial direction from the optical axis xₒ of the light beam as emitted by the second type of PC-LED package 411. Hence, when first type of LED-packages 411 are combined with second type of LED packages 412 in a single light source, the undesired effect of CoA is relatively low in the light beam emitted by said light source. The present disclosure thus provides a technique for mitigating the effect of CoA behavior, which can be used to provide an improved light source 110 and/or luminaire 100 (see Figure 1C).

It has been herein recognized that an LED package containing a PC-LED can be formed in two different types. A first type of package comprises a PC-LED with a respective dome-shaped lens and respective collimating reflector. A second type of package comprises a PC-LED without a respective dome-shaped lens and without a respective collimating reflector (e.g., a lens-less LED package or a bare PC-LED package).

An LED package represents a single unit of an array of LED packages.

Figure 1C illustrates a luminaire 100 for improved contextual understanding. The luminaire 100 represents one environment in which proposed embodiments can be employed. The luminaire 100 is a collimating luminaire, in that it is designed to produce and output collimated light, as set out below.

The luminaire 100 also provides an example of a LED lighting arrangement.

The luminaire 100 comprises a light source 110, a common lens 120, a common reflector 130 and a light output window 140 (which may be formed in the reflector 130). The light source 110 is configured to emit light, e.g., when powered or driven. The common lens 120 and common reflector 130 work together to collimate the light emitted or output by the light source 110, e.g., to reduce the beam angle of light output by the light source. The light source 110 comprises a mix of a plurality of the first type of LED packages 411 and a plurality of the second type of LED packages 412.

The common lens 120 is configured to perform beamshaping on a portion of the light emitted by the light source 110, e.g., using well-known refraction or scattering techniques. The beamshaped light is then output through the light output window 140. Figure 1 illustrates a first 191 and second 192 light ray that undergo beamshaping by the common lens 120 for illustrative understanding. The portion of the light beamshaped by the common lens 120 comprises light having relatively small angles (e.g., FWHM <= 30°, <=45° or <=60°) with respect to an optical axis xₒ of the luminaire 100 or light source 110.

The common reflector 130 is configured to redirect a portion of the light output by the light source 110 towards the light output window 140 using reflection, e.g., total internal reflection or via the use of reflective materials (such as (polished) silver or aluminum). Figure 1 illustrates a third light ray 193 and a fourth light ray 194 that undergo reflection by the common reflector 130 for illustrative understanding. The portion of light (emitted by the light source 110) that undergoes reflection by the common reflector 130 comprises light that is not incident upon the common lens 120, e.g., light having relatively large angles with respect to the optical axis xₒ of the luminaire.

Of course, there may be a portion of light that bypasses both the common lens 120 and the common reflector 130, i.e., moves directly from the light source 110 to the light exit window 140. This is usually negligible or very small, and it is possible to design the common lens and common reflector such that no/minimal light avoids these elements.

There is an increasing desire to form the light source 110 from an array of LEDs or LED packages (each comprising an LED), due to their efficiency of use. Phosphor-converted light emitting diodes (PC-LEDs) have been seen as the next generation of solidstate lighting technology. Such LEDs comprise a base light emitting diode that emits blue light, sometimes called "blue pump light". This blue pump light is then passed through a partially absorbing phosphor that effectively converts some of the blue light to other colors of light ("phosphor-converted light"), creating a white spectrum of light output by the overall LED or LED package.

However, it is recognized that as the angle of the light emitted at large angles with respect to the optical axis of the PC-LED increases, so the optical path of the blue pump light through the partially absorbing phosphor increases. This leads to increased absorption by the partially-absorbing phosphor, such that light emitted at larger angles by the overall PC-LED has less blue light than at smaller angles. This is called the Color-over-Angle (CoA) effect or behavior.

Figure 2 illustrates the intensity distribution or spread of yellow light emitted by different types of LED packages containing a PC-LED. The axes of the graph depict luminous intensity (measured in cd/klm) over angle θ of emitted light with respect to the optical axis (measured in degrees °).

A first line 210 illustrates the intensity distribution of yellow light for an LED package having a PC-LED and a respective dome-shaped lens and respective collimating reflector. A second line 220 illustrates the intensity distribution of yellow light for an LED package containing a PC-LED, but without a respective dome-shaped lens and without a respective collimating reflector, e.g., a lens-less PC-LED package.

As illustrated in Figure 2, the distribution of yellow light is largely unaffected by the presence or absence of a respective dome-shape lens and respective collimating reflector.

Figure 3 illustrates the intensity distribution or spread of blue light emitted by different types of packages containing an PC-LED. The axes of the graph depict luminous intensity (measured in cd/klm) over angle θ of emitted light with respect to the optical axis (measured in degrees °).

A first line 310 illustrates the intensity distribution of blue light for an LED package having a PC-LED and a respective dome-shaped lens and respective collimating reflector. A second line 320 illustrates the intensity distribution of blue light for an LED package having a PC-LED, but without a dome-shaped lens and without a respective collimating reflector, e.g., a lens-less PC-LED package.

As illustrated in Figure 3, the distribution of blue light output by an LED package is impacted by the presence or absence of a/the respective dome-shaped lens and respective collimating reflector within the LED package. In particular, the combination of the respective dome-shaped lens and respective collimating reflector acts to concentrate the blue part of the spectrum closer to the optical axis. Thus, compared to an LED package comprising a PC-LED, but without a respective dome-shaped lens and respective collimating reflector, more blue light is emitted at angles closer to the optical axis than at angles more distance from the optical axis.

The present disclosure proposes to take advantage of this recognition in order to compensate for the spread of intensities. In particular, by providing a common lens array that comprises a mix of one or more LED packages comprising a respective dome-shaped lens and a respective collimating reflector and one or more LED packages without a respective dome-shaped lens and respective collimating reflector, a more uniform distribution of light color will be output by the overall array of LED packages, e.g., compared to a solution that makes use of only a single one of these types of LED package.

In this way, by mixing the use of different types of LED package (e.g., on a same chip or substrate), proposed embodiments can improve the uniformity of color throughout the light distribution by effectively compensating opposite behaviors from first and second types of LED package. The resulting light beam output ends up with compensated blue and yellow contributions emitted by the array of LED packages throughout its output light distribution.

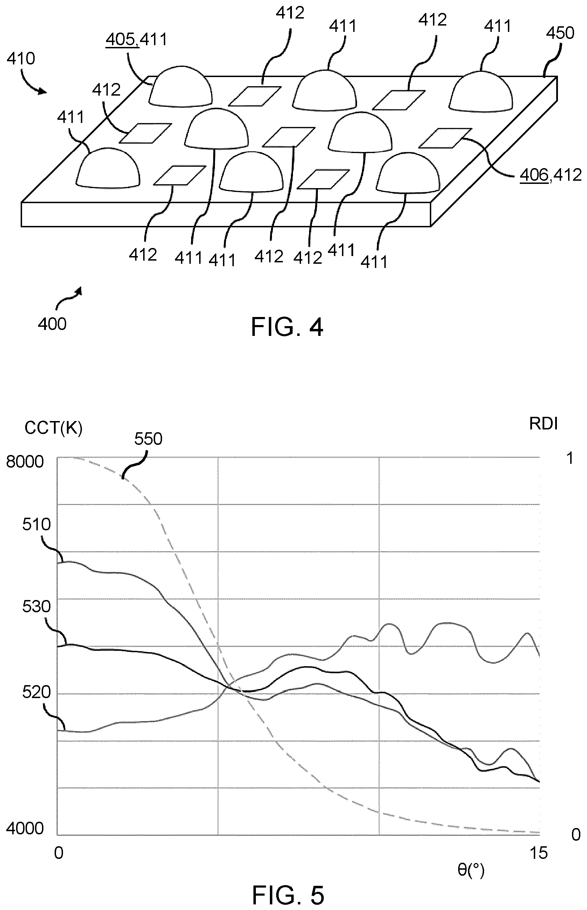

Figure 4 illustrates a portion of an LED lighting arrangement 400 according to an embodiment. The LED lighting arrangement comprise an array of LED packages 410 (which may form the light source for the overall LED lighting arrangement). The array of LED packages comprises (only) a first set 405 of one or more LED packages 411 and a second set 406 of one or more LED packages 412. Each LED package in the first set has an LED and a respective dome-shaped lens and respective collimating reflector. Each LED in the second set has a LED, but does neither have a respective dome-shaped lens nor a respective collimating reflector(e.g., comprises only a bare LED).

Each LED in the first and second set of one or more LED packages is a phosphor-converted white light emitting diode, i.e., each LED is a PC-LED.

In some examples, no fewer than 90% of the LEDs in the array of LED packages comprise the same phosphor (i.e., made out of the same material) for performing conversion of light. Put another way, in no fewer than 90% of the LEDs, the phosphor of the phosphor-converted light emitting diode may be of a same material. In particular examples, each LED in the array of LED packages comprise the same material as phosphor.

Each LED package may comprise only a single PC-LED, such that there are as many LEDs in the array of LED packages as there are LED packages. However, this is not essential and some variants may comprise a plurality of LEDs per LED package.

Preferably, and as illustrated, the number of LED packages in the first set and the number of LED packages in the second set is the same or nearly the same. For instance, the first set of one or more LED packages and the second set of one or more LED packages may each comprise no fewer than 45% of the total number of LED packages in the array of LED packages.

More particularly, the ratio of the number of LED packages in the first set to the number of LED packages in the second set may be a ratio between 0.9 and 1.1.

The array of LED packages may be mounted on a substrate or carrier 450. Thus, the LED lighting arrangement may comprise a single substrate or carrier that carries the array of LED packages. In particular, each package of the array of LED packages can be formed in/on a same chip, so that a single chip comprises or carries the first set of one or more LED packages and the second set of one or more LED packages.

Each LED package may be driven from a same power supply or source, e.g., be powered by a same driver. However, this is not essential, and other examples may drive different groupings or clusters of LED packages according to a desired control scheme. Approaches are well known to the skilled person.

Preferably, the first set of one or more LED packages comprises no fewer than 10 LED packages and/or the second set of one or more LED packages comprises no fewer than 10 LED packages. Thus, the total number of LED packages in the array of LED packages may, for instance, be no less than 20 LED packages.

In the illustrated example, the second set of one or more LED packages are interspersed amongst the first set of one or more LED packages. The first and second LED packages form a particular pattern in which each LED package in a first set neighbors one or more LED packages from the second set. More specifically, the LED packages are arranged in a grid in which the first and second sets of LED packages interleave or alternate with one another along both a column direction and a row direction.

Figure 5 illustrates the effect of having equal or near-equal numbers of LED packages in the first and second sets.

In particular, Figure 5 illustrates the color uniformity of an array of LED packages formed from different mixes of the first and second type of LED package. A y-axis depicts the correlated color temperature (CCT) of the light, with the x-axis depicting the angle (θ) of the light emitted by the array of LED packages with respect to an optical axis of the LED package.

A first line 510 illustrates the CCT over angle for an array of LED packages comprising only LED packages each having a respective dome-shaped lens and a respective collimating reflector. A second line 520 illustrates the CCT over angle for an array of LED packages comprising only LED packages each without a respective dome-shaped lens and without a respective collimating reflector.

A third line 530 illustrates the CCT over angle for an array of LED packages comprising an even mix of LED packages having a respective dome shaped lens and a respective collimating reflector and LED packages without a respective dome-shaped lens and without a respective collimating reflector. Thus, for producing the third line 530, the number of LED packages having a respective dome shaped lens and a respective collimating reflector is equal to the number of LED packages not having a respective dome shaped lens (e.g., absent any lens at all) and no respective collimating reflector. This clearly demonstrates how an improved uniformity of color is achieved by mixing the two types of LED packages.

Although advantageous, it is not essential that there be equal numbers of LED packages in the first set and the second set. Rather, different combinations, ratios or mixes of LED packages of different types could be used whilst still achieving an improved LED lighting arrangement over those known in the art.

For instance, the first set of one or more LED packages comprises no fewer than 30% of the total number of LED packages in the array of LED packages, e.g., no fewer than 45% of the total number of LED packages in the array of LED packages.

Similarly, the second set of one or more LED packages may comprise no fewer than 30% of the total number of LED packages in the array of LED packages, e.g., no fewer than 45% of the total number of LED packages in the array of LED packages.

For completeness, Figure 5 also illustrates the relative distribution intensity (RDI) 550 of light output by the array of LED packages with respect to the angle of light output by the array of LED packages.

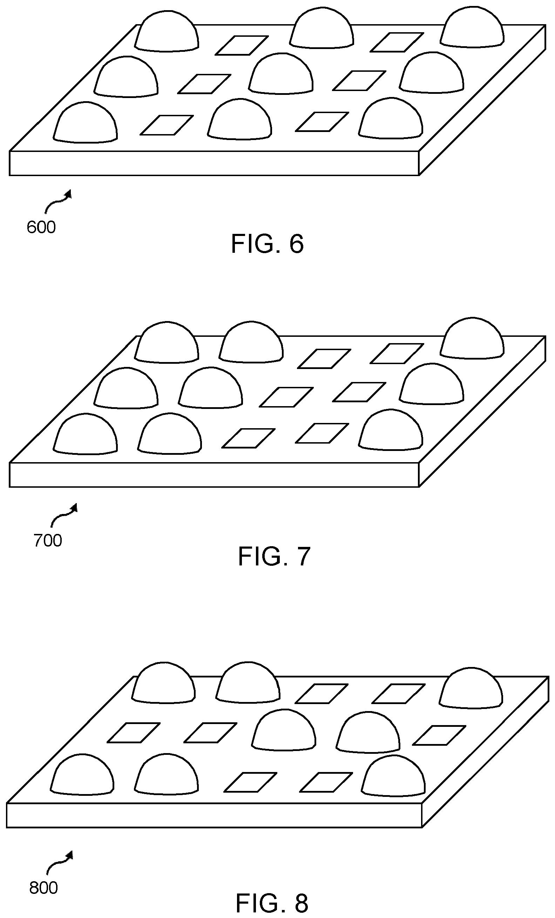

Figure 6, 7 and 8 illustrate variations for the pattern of the first and second set of one or more LED packages.

Figure 6 illustrates a first pattern 600 in which the LED packages are arranged in a grid in which the first and second sets of LED packages interleave or alternate with one another along a row direction only.

Figure 7 illustrates a second pattern 700 in which the LED packages are arranged in a grid in which each of the first and second sets of LED packages form sub-sets of two columns, each subset interleaving or alternating with one another along a row direction only. The number of columns for each sub-set may be greater than 2 in variants of the second pattern, e.g. 3 columns, 4 columns, 5 columns or more.

Figure 8 illustrates a third pattern 800 in which the LED packages of each set are grouped into sub-sets of two LED packages. Each sub-set of the first set of one or more LED packages neighbors at least one sub-set of the second set of one or more LED packages in a grid-like formation. The number of packages for each sub-set may be greater than 2 in variants of the third pattern, e.g. 3 packages, 4 packages, 5 packages or more.

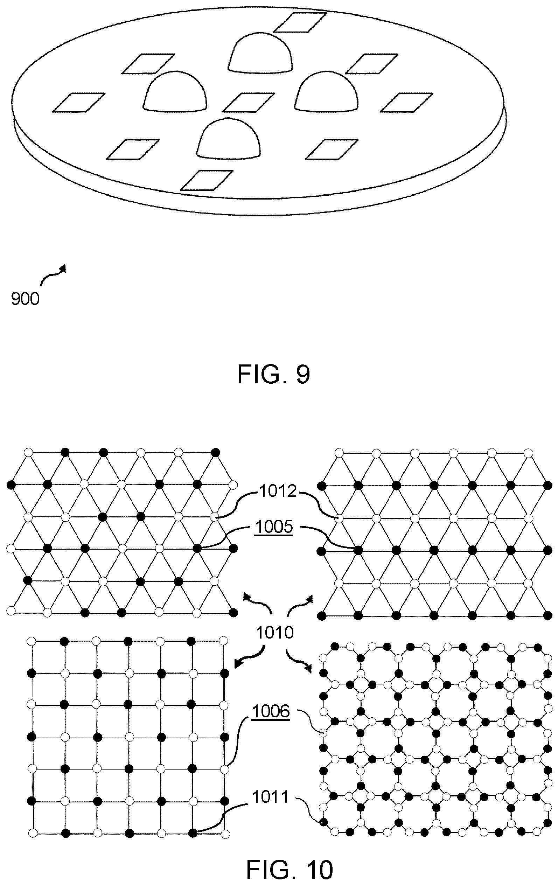

Figure 9 illustrates a fourth pattern 900 in which the LED packages are positioned in concentric circles, which are configured to alternate (between belonging to the first set and belonging to the second set) in a radial direction.

These example patterns are non-exhaustive, and serve to show that any suitable arrangement or pattern for distributing the first and second LED packages within an LED package array can be used. In this respect Figure 10 shows some simplified, schematic examples, of an array of LED packages 1010 in a triangular grid, a square grid, and a grid formed by squares and octagons. The black circles are first type of LED packages 1011 that are part of the first set 1005 and white circles are second type of LED packages 1012 that are part of the second set 1006. A shown, in the square grid and the grid formed by squares and octagons, each first type of LED package 1011 only has second type of LED packages 1012 as closest neighbors and vice versa.

Turning back to Figure 1, the proposed array of LED packages can be integrated into the luminaire 100 or LED lighting arrangement. In particular, any proposed array of LED packages may form the light source 110 for the luminaire 100 or LED lighting arrangement.

Moreover, the LED lighting arrangement may comprise a common reflector 130 for collimating light output by the array of LED packages. The common reflector is distinguished from the respective collimating reflector 000 for the individual LED packages in that it is positioned and configured to receive light emitted by the array of LED packages, e.g., from each LED package in the array instead of from an individual LED package.

Similarly, the LED lighting arrangement may comprise a common lens 120, distanced from the array of LED packages, for performing beamshaping on light output by the array of LED packages. The common lens is distinguished from the respective dome-shaped lens for the individual LED packages in that it is positioned and configured to receive light emitted by the array of LED packages, e.g., from each LED package in the array instead of from an individual LED package.

In the context of the present invention, an LED package may have a respective dome-shaped lens and respective collimating reflector if the LED of the LED package is less than 2mm away from a respective dome-shaped lens and/or if the respective dome-shaped lens is designed to receive light from only that LED. In particular, an LED package may have a respective dome-shaped lens and respective collimating reflector if the lens of that LED package receives substantially all of the light from the LED of that package and is within 5mm (or more preferably 2mm) of said LED of said package.

An LED package may be considered to not have a respective dome-shaped lens and not have a respective collimating reflector if there is no lens within 2mm from the LED of said package and/or if the nearest lens to that LED is configured or designed to receive light from a plurality of LEDs. In particular, an LED package may be considered to not have a respective dome-shaped lens and not have a respective collimating reflector if there is no dome-shaped lens configured to receive substantially all of the light from the LED of that package within 5mm (or more preferably within 2mm) of that LED.

For the sake of illustrative clarity, other potential elements of an LED lighting arrangement are not illustrated, to draw closer attention to the underlying concept herein proposed. These other potential elements may include driving/powering circuitry; control circuitry; color filters; mounting systems; communication circuitry and so on. The skilled person would readily appreciate how herein proposed concepts can be applied to LED lighting arrangements comprising such elements.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

If the term "adapted to" is used in the claims or description, it is noted the term "adapted to" is intended to be equivalent to the term "configured to". If the term "arrangement" is used in the claims or description, it is noted the term "arrangement" is intended to be equivalent to the term "system", and vice versa.

Any reference signs in the claims should not be construed as limiting the scope.

## Claims

1. An LED lighting arrangement (100) comprising an array (410) of LED packages, the array of LED packages comprising:
a first set (405) of one or more first type of LED packages (411), each first type of LED package set having an LED (200) and a respective combination of a dome-shaped lens (161) and a collimating reflector (160); and
a second set (406) of one or more second type of LED packages (412), each second type of LED package set having an LED (200) and being free from a respective dome-shaped lens and from a respective, collimating reflector,
**characterized in that** each LED in the first and second set of one or more LED packages is a phosphor-converted light emitting diode.

2. The LED lighting arrangement of claim 1, wherein the first set of one or more LED packages comprises no fewer than 30% of the total number of LED packages in the array of LED packages.

3. The LED lighting arrangement of claim 2, wherein the first set of one or more LED packages comprises no fewer than 45% of the total number of LED packages in the array of LED packages.

4. The LED lighting arrangement of any of claims 1 to 3, wherein the second set of one or more LED packages comprises no fewer than 30% of the total number of LED packages in the array of LED packages.

5. The LED lighting arrangement of claim 4, wherein the second set of one or more LED packages comprises no fewer than 45% of the total number of LED packages in the array of LED packages.

6. The LED lighting arrangement of any of claims 1 to 5, wherein the first set of one or more LED packages and the second set of one or more LED packages each comprise no fewer than 45% of the total number of LED packages in the array of LED packages.

7. The LED lighting arrangement of any of claims 1 to 6, wherein the first set of one or more LED packages comprises no fewer than 10 LED packages, and wherein the second set of one or more LED packages comprises no fewer than 10 LED packages.

8. The LED lighting arrangement of any of claims 1 to 7, wherein each combination of the respective collimating reflector (160) and the dome-shaped lens (161) is a single, integrated, optical element.

9. The LED lighting arrangement of any of claims 1 to 8, wherein each LED in the first and second set of one or more LED packages is a phosphor-converted white light light emitting diode.

10. The LED lighting arrangement of any of claims 1 to 9, wherein the second set of one or more LED packages are interspersed amongst the first set of one or more LED packages.

11. The LED lighting arrangement of any of claims 1 to 10, further comprising a common reflector for collimating light output by the array of LED packages.

12. The LED lighting arrangement of any of claims 1 to 11, further comprising a common lens, distanced from the array of LED packages, for performing beamshaping on light output by the array of LED packages.

13. The LED lighting arrangement of any of claims 1 to 12, wherein no fewer than 90% of the LEDs in the array of LED packages comprise the same phosphor for performing conversion of light.

14. The LED lighting arrangement of any of claims 1 to 13, wherein the first and second sets of one or more LED packages are arranged in a grid in which the first and second sets of one or more LED packages alternate with one another along both a column direction and a row direction.

## Patentansprüche

1. LED-Beleuchtungsanordnung (100), umfassend ein Array (410) von LED-Gehäusen, das Array von LED-Gehäusen umfassend:
einen ersten Satz (405) von einem oder mehreren LED-Gehäusen (411) einer ersten Art, wobei jeder Satz von LED-Gehäusen der ersten Art eine LED (200) und eine jeweilige Kombination aus einer kuppelförmigen Linse (161) und einem kollimierenden Reflektor (160) aufweist; und
einen zweiten Satz (406) von einem oder mehreren LED-Gehäusen (412) einer zweiten Art, wobei jeder Satz von LED-Gehäusen der zweiten Art eine LED (200) aufweist und frei von einer jeweiligen kuppelförmigen Linse und von einem jeweiligen kollimierenden Reflektor ist,
**dadurch gekennzeichnet, dass** jede LED in dem ersten und dem zweiten Satz von einem oder mehreren LED-Gehäusen eine leuchtstoffkonvertierte Leuchtdiode ist.

2. LED-Beleuchtungsanordnung nach Anspruch 1, wobei der erste Satz von einem oder mehreren LED-Gehäusen nicht weniger als 30 % der Gesamtzahl von LED-Gehäusen in dem Array von LED-Gehäusen umfasst.

3. LED-Beleuchtungsanordnung nach Anspruch 2, wobei der erste Satz von einem oder mehreren LED-Gehäusen nicht weniger als 45 % der Gesamtzahl von LED-Gehäusen in dem Array von LED-Gehäusen umfasst.

4. LED-Beleuchtungsanordnung nach einem der Ansprüche 1 bis 3, wobei der zweite Satz von einem oder mehreren LED-Gehäusen nicht weniger als 30 % der Gesamtzahl von LED-Gehäusen in dem Array von LED-Gehäusen umfasst.

5. LED-Beleuchtungsanordnung nach Anspruch 4, wobei der zweite Satz von einem oder mehreren LED-Gehäusen nicht weniger als 45 % der Gesamtzahl von LED-Gehäusen in dem Array von LED-Gehäusen umfasst.

6. LED-Beleuchtungsanordnung nach einem der Ansprüche 1 bis 5, wobei der erste Satz von einem oder mehreren LED-Gehäusen und der zweite Satz von einem oder mehreren LED-Gehäusen jeweils nicht weniger als 45 % der Gesamtzahl von LED-Gehäusen in dem Array von LED-Gehäusen umfassen.

7. LED-Beleuchtungsanordnung nach einem der Ansprüche 1 bis 6, wobei der erste Satz von einem oder mehreren LED-Gehäusen nicht weniger als 10 LED-Gehäuse umfasst und wobei der zweite Satz von einem oder mehreren LED-Gehäusen nicht weniger als 10 LED-Gehäuse umfasst.

8. LED-Beleuchtungsanordnung nach einem der Ansprüche 1 bis 7, wobei jede Kombination des jeweiligen kollimierenden Reflektors (160) und der kuppelförmigen Linse (161) ein einziges, integriertes, optisches Element ist.

9. LED-Beleuchtungsanordnung nach einem der Ansprüche 1 bis 8, wobei jede LED in dem ersten und dem zweiten Satz von einem oder mehreren LED-Gehäusen eine leuchtstoffkonvertierte Weißlichtleuchtdiode ist.

10. LED-Beleuchtungsanordnung nach einem der Ansprüche 1 bis 9, wobei der zweite Satz von einem oder mehreren LED-Gehäusen unter den ersten Satz von einem oder mehreren LED-Gehäusen eingestreut ist.

11. LED-Beleuchtungsanordnung nach einem der Ansprüche 1 bis 10, ferner umfassend einen gemeinsamen Reflektor zum Kollimieren von Licht, das durch das Array von LED-Gehäusen ausgegeben wird.

12. LED-Beleuchtungsanordnung nach einem der Ansprüche 1 bis 11, ferner umfassend eine gemeinsame Linse, die von dem Array von LED-Gehäusen beabstandet ist, zum Durchführen eines Strahlformens an Licht, das durch das Array von LED-Gehäusen ausgegeben wird.

13. LED-Beleuchtungsanordnung nach einem der Ansprüche 1 bis 12, wobei nicht weniger als 90 % der LEDs in dem Array von LED-Gehäusen den gleichen Leuchtstoff zum Durchführen einer Lichtumwandlung umfassen.

14. LED-Beleuchtungsanordnung nach einem der Ansprüche 1 bis 13, wobei der erste und der zweite Satz von einem oder mehreren LED-Gehäusen in einem Raster angeordnet sind, in dem sich der erste und der zweite Satz von einem oder mehreren LED-Gehäusen entlang sowohl einer Spaltenrichtung als auch einer Zeilenrichtung abwechseln.

## Revendications

1. Agencement d'éclairage à DEL (100) comprenant un réseau (410) de boîtiers de DEL, le réseau de boîtiers de DEL comprenant :
un premier ensemble (405) d'un ou plusieurs premiers types de boîtiers de DEL (411), chaque premier type d'ensemble de boîtiers de DEL comportant une DEL (200) et une combinaison respective d'une lentille en forme de dôme (161) et d'un réflecteur de collimation (160) ; et
un second ensemble (406) d'un ou plusieurs seconds types de boîtiers de DEL (412), chaque second type d'ensemble de boîtiers de DEL comportant une DEL (200) et étant exempt d'une lentille en forme de dôme respective et d'un réflecteur de collimation respectif,
**caractérisé en ce que** chaque DEL dans les premier et second ensembles d'un ou plusieurs boîtiers de DEL est une diode électroluminescente à conversion par phosphore.

2. Agencement d'éclairage à DEL selon la revendication 1, dans lequel le premier ensemble d'un ou plusieurs boîtiers de DEL ne comprend pas moins de 30 % du nombre total de boîtiers de DEL dans le réseau de boîtiers de DEL.

3. Agencement d'éclairage à DEL selon la revendication 2, dans lequel le premier ensemble d'un ou plusieurs boîtiers de DEL ne comprend pas moins de 45 % du nombre total de boîtiers de DEL dans le réseau de boîtiers de DEL.

4. Agencement d'éclairage à DEL selon l'une quelconque des revendications 1 à 3, dans lequel le premier ensemble d'un ou plusieurs boîtiers de DEL ne comprend pas moins de 30 % du nombre total de boîtiers de DEL dans le réseau de boîtiers de DEL.

5. Agencement d'éclairage à DEL selon la revendication 4, dans lequel le second ensemble d'un ou plusieurs boîtiers de DEL ne comprend pas moins de 45 % du nombre total de boîtiers de DEL dans le réseau de boîtiers de DEL.

6. Agencement d'éclairage à DEL selon l'une quelconque des revendications 1 à 5, dans lequel le premier ensemble d'un ou plusieurs boîtiers de DEL et le second ensemble d'un ou de plusieurs boîtiers de DEL comprennent chacun pas moins de 45 % du nombre total de boîtiers de DEL dans le réseau de boîtiers de DEL.

7. Agencement d'éclairage à DEL selon l'une quelconque des revendications 1 à 6, dans lequel le premier ensemble d'un ou plusieurs boîtiers de DEL comprend pas moins de 10 boîtiers de DEL, et dans lequel le second ensemble d'un ou plusieurs boîtiers de DEL comprend pas moins de 10 boîtiers de DEL.

8. Agencement d'éclairage à DEL selon l'une quelconque des revendications 1 à 7, dans lequel chaque combinaison du réflecteur de collimation respectif (160) et de la lentille en forme de dôme (161) est un seul élément optique intégré.

9. Agencement d'éclairage à DEL selon l'une quelconque des revendications 1 à 8, dans lequel chaque DEL dans les premier et second ensembles d'un ou plusieurs boîtiers de DEL est diode électroluminescente à lumière blanche à conversion par phosphore.

10. Agencement d'éclairage à DEL selon l'une quelconque des revendications 1 à 9, dans lequel le second ensemble d'un ou plusieurs boîtiers de DEL est intercalé dans le premier ensemble d'un ou de plusieurs boîtiers de DEL.

11. Agencement d'éclairage à DEL selon l'une quelconque des revendications 1 à 10 comprenant en outre un réflecteur commun pour collimater la lumière émise par le réseau de boîtiers de DEL.

12. Agencement d'éclairage à DEL selon l'une quelconque des revendications 1 à 11, comprenant en outre une lentille commune, éloignée du réseau de boîtiers de DEL, pour réaliser une mise en forme du faisceau sur la lumière émise par le réseau de boîtiers de DEL.

13. Agencement d'éclairage à DEL selon l'une quelconque des revendications 1 à 12, dans lequel pas moins de 90 % des DEL dans le réseau de boîtiers de DEL comprennent le même phosphore pour effectuer une conversion de la lumière.

14. Agencement d'éclairage à DEL selon l'une quelconque des revendications 1 à 13, dans lequel les premier et second ensembles d'un ou plusieurs boîtiers de DEL sont agencés dans une grille dans laquelle les premier et second ensembles d'un ou plusieurs boîtiers de DEL s'alternent l'un avec l'autre tant dans le sens de colonne que dans le sens de ligne.
